# EUROPÄISCHE PATENTSCHRIFT

(11) **EP 0 633 545 B1**
(45) Veröffentlichungstag und Bekanntmachung des Hinweises auf die Patenterteilung: **27.10.1999**
(21) Anmeldenummer: 94109693.5
(22) Anmeldetag: 23.06.1994
(51) Int. Cl.: G01F 15/06, G06M 1/27, G01R 11/16

(54) **Mehrstelliges Rollenzählwerk mit Encoder**
Multi-digit roller-counter having an encoder
Compteur à rouleaux à plusieurs chiffres avec un codeur

(30) Priorität: 11.07.1993 CH 205993
(43) Veröffentlichungstag der Anmeldung: 11.01.1995
(73) Patentinhaber: GWF Gas- & Wassermesserfabrik AG, CH-6002 Luzern (CH)
(72) Erfinder: Mettler, Roland, Dipl.-Phys. ETH, CH-6010 Kriens (CH)
(74) Vertreter: Blöchle, Hans

(56) Entgegenhaltungen:
- FR-A- 2 666 886
- US-A- 4 683 472

## Beschreibung

Die Erfindung betrifft ein mehrstelliges Rollenzählwerk für Volumen- oder Strommessung, dessen Zählerstand mit einem zum Auslesen jeweils zu aktivierenden Encoder elektronisch abgelesen werden kann.

Es sind Volumenmessgeräte für Gas und Wasser wie auch Elektrizitätszähler zur Messung der durchgeströmten Energie bekannt, in welchen das gemessene Volumen respektive die gemessene Energie mit einer dem Messgerät angepassten Untersetzung auf ein mechanisches Rollenzählwerk übertragen wird. Das Rollenzählwerk zeigt dabei die seit der letzten Nullstellung respektive die seit der Inbetriebnahme durchgeflossene Menge an. Zur Bestimmung des Verbrauchs während einer bestimmten Periode wird der Stand des Rollenzählwerkes zu Beginn und am Ende dieser Periode abgelesen. Eine bevorzugte Ausführung für das Rollenzählwerk besteht aus einer Achse, auf welcher die Zahlenrollen drehbar angebracht sind und auf deren Umfang die Ziffern 0 bis 9 aufgebracht sind, sowie aus einer zweiten Achse mit darauf drehbaren Schaltritzeln derart, dass jeweils die kleinerwertige Zahlenrolle im letzten Zehntel einer Umdrehung über das zugeordnete Schaltritzel die nächst höherwertige Rolle um eine Zehntelumdrehung weiterschaltet. Ein Rollenzählwerk für ein Messgerät für Wasser findet sich zum Beispiel in DE-OS 22 44 404. Je nach Ausführung des Messgerätes ist es zur Erzielung eines grossen Messbereichs mit einer guten Messgenauigkeit wichtig, das zum Antrieb des Rollenzählwerkes erforderliche Drehmoment möglichst klein zu halten.

Aus US-A-3 732 404 ist eine Lösung zur elektronischen Auslesung eines Zählwerkes bekannt, in welcher die kontinuierliche Drehbewegung der Zahlenrollen in eine schnappende Bewegung übersetzt wird. Dazu ist sicherzustellen, dass die für die schnappende Bewegung verwendete Feder o.ä. genügend Energie aufnimmt, um das ganze Rollenpaket eine Stellung vorwärts zu drehen, beispielsweise von 19999 auf 20000. Aus der EP 202722 B1 ist eine Lösung bekannt, welche die elektronische Auslesung für ein Zählwerk vom Nadeltyp unter der Verwendung von mechanischen Kontakten ohne Schnappbewegung erlaubt. Natürlich ist es auch möglich, ein Zählwerk vom Nadeltyp im Gleichlauf zu einem Zählwerk mit Rollenzählwerk einzusetzen.

Aus der US-A-4,683,472 ist ein Elektrizitätszähler mit einem Zählwerk bekannt. Das Zählwerk (odometer 86) ist als mechanisches Rollenzählwerk ausgeführt, welches von einem Schrittmotor angetrieben wird. Die Pulse für den Schrittmotor werden mittels Abtastung der Geschwindigkeit einer sich bei Strombezug rotierenden Ferrarisscheibe und einer nachfolgenden Verstärker- und Pulsmodulationsschaltung erzeugt. Die Auslesung des Zählerstandes erfolgt elektromechanisch mittels Schleifkontakten an den Zählrollen, welche bei einer ganzen Drehung jeder Zehner-Zählrolle über zehn Kontaktflächen von feststehenden gedrucktenSchaltungen schleifen. Von jeder gedruckten Schaltung führen elf elektrische Leiter nach aussen. Entsprechend der momentanen Stellung zwischen 0 und 9 einer Zählrolle wird so eine elektrische Verbindung zwischen einer der zehn Kontaktflächen 0-9 und einem Zentrumsabgriff hergestellt.

Diese elektromechanische, nicht codierte Abbildung der Zählerstellung benötigt eine umfangreiche Verdrahtung und weist die bekannten Nachteile eines elektromechanischen Systems auf, wie z.B. Defektanfälligkeit durch Abnützung und/oder Oxydation der mechanischen Kontakte. Diese Einrichtung kann daher nicht mehr heutige Ansprüche an Zuverlässigkeit und Wartungsfreiheit erfüllen.

Der vorliegenden Erfindung liegt die Aufgabe zugrunde, den Anzeigestand eines Rollenzählwerkes in einem Messgerät mit möglichst einfachen Mitteln zu einem beliebigen Zeitpunkt digital elektronisch auszulesen, ohne dass das zum Antrieb des Rollenzählwerkes erforderliche Drehmoment durch die dazu notwendigen Mittel wesentlich erhöht wird.

Gemäss vorliegender Erfindung werden zwischen den Zahlenrollen drehbare Sensoren angebracht, welche auf unterschiedlich voneinander entfernte Markierungen auf den Zahlenrollen ansprechen. Beispielsweise können die Markierungen in den Abständen von 9°, 72°, 27°, 63°, 36°, 54°, 18°, 81° rundum auf der Zahlenrolle verteilt angebracht sein. Durch Verdrehen der Sensoren um mindestens 99° werden mindestens zwei Markierungen erkannt. Aus dem Winkelabstand zwischen zwei Markierungen kann abgeleitet werden, um welche beiden Markierungen es sich handelt, gleichzeitig wird die Stellung einer der Markierungen dazu verwendet, die Stellung der Zahlenrolle zu bestimmen.

Vorteile der vorliegenden Erfindung sind ein kleiner Drehwinkel für die Sensoren und eine sehr geringe Reibungserhöhung.

Eine vorteilhafte Ausführung der Sensoren besteht aus radial oder axial angebrachten Lichtschranken, welche Öffnungen respektive Stege als Markierungen erkennen. Eine andere Sensorvariante besteht aus Induktivsensoren mit Materialien unterschiedlicher Wirbelstromdämpfung oder Magnetisierung als Markierungen.

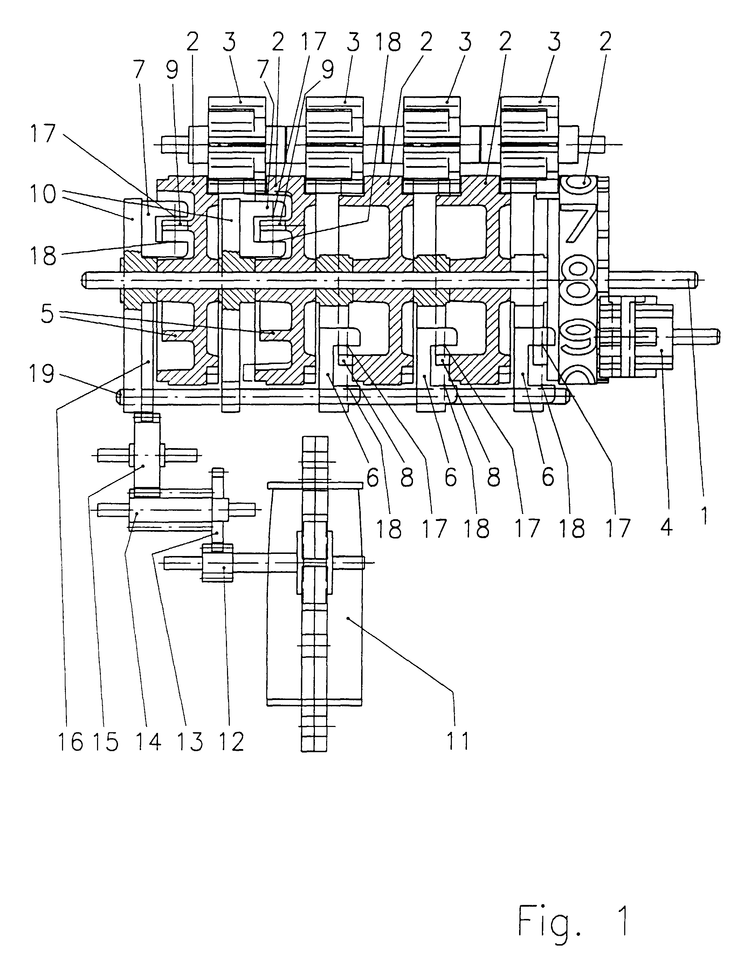

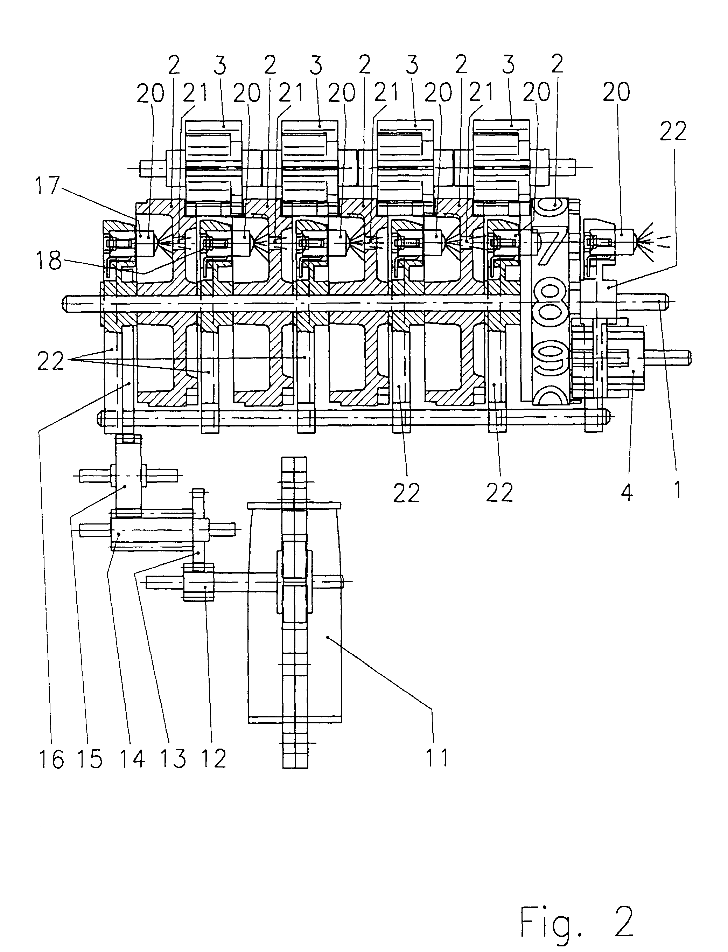

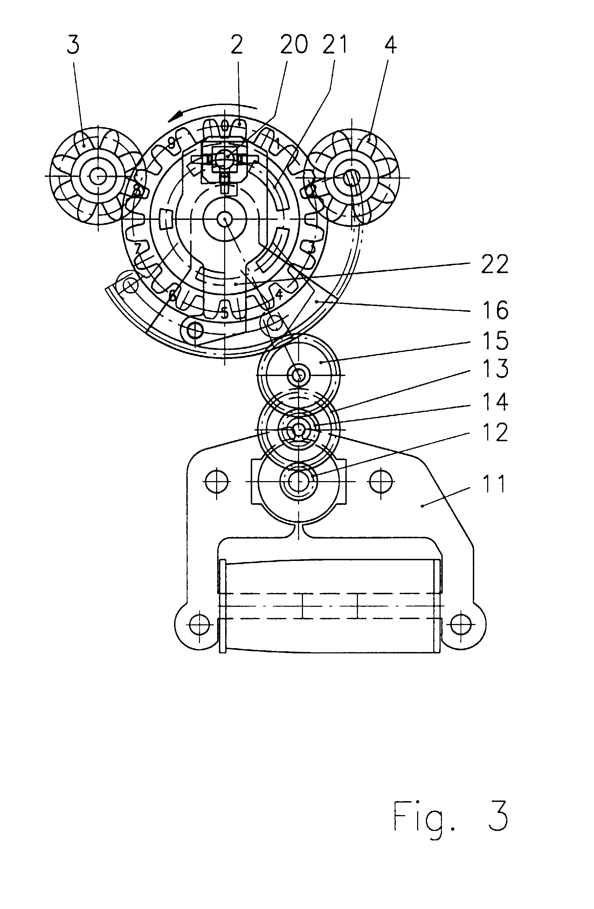

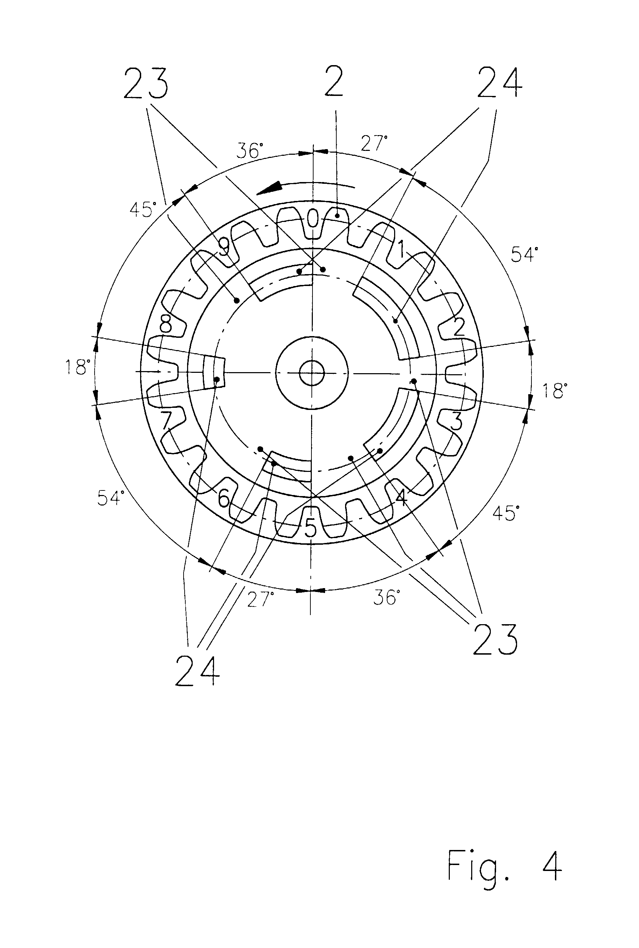

Im folgenden werden Ausführungsdetails und Funktion für eine Ausführung mit optischen Sensoren beschrieben. Eine solche bevorzugte Ausführung der optischen Sensoren besteht aus Lichtschranken, welche auf Armen befestigt sind. Figur 1 zeigt ein erstes Ausführungsbeispiel mit Gabellichtschranken im Längsschnitt, die Figuren 2 bis 4 zeigen ein zweites Ausführungsbeispiel mit achsialen Lichtschranken.

Bei dem in Figur 1 dargestellten Rollenzählwerk sind auf einer Zahlenrollenachse 1 frei drehbar mehrere Zahlenrollen 2 angeordnet, die über Schaltritzel 3 mechanisch miteinander in Verbindung stehen. Die Schaltritzel 3 sitzen auf einer separaten Schaltritzelachse. Die niederwertigste Zahlenrolle 2 wird zum Messen durch ein Zahnrad 4 angetrieben. Die Zahlenrollen 2 sind üblicherweise durch eine nicht dargestellte Blende in herkömmlicher Weise visuell ablesbar.

Zum elektronischen Auslesen sind an den Zahlenrollen 2 auf einem bestimmten Radius Markierungen 5 angebracht, vorzugsweise in Form von Ringsegmenten unterschiedlicher Länge, wie dies im zweiten Ausführungsbeispiel näher erläutert ist. Zwischen den Zahlenrollen 2 sind als erste Einrichtungen zur Detektion des Zählerstandes Gabellichtschranken 6,7 angeordnet, die entweder einen Aussenkranz 8 oder einen Innenkranz 9 der Zahlenrollen 2 umgreifen. Die Markierungen 5 befinden sich an den Kränzen 8, 9. An den Gabelenden sind einander zugekehrt je eine Lichtquelle 17 und ein Lichtempfänger oder optischer Sensor 18 angebracht. Die Lichtschranken 6,7 sind auf um die Zahlenrollenachse 1 drehbaren, scheiben- oder hebelförmigen Armen 10 befestigt. Durch die Arme 10 hindurchgeführt ist eine Stange 19. Sie verbindet die Arme 10 radial ausserhalb der Zahlenrollen 2 miteinander, sodass sie synchron verdreht werden können. Eine andere Ausführungsvariante besteht darin, die Arme 10 auf der Zahlenrollenachse 1 unverdrehbar zu befestigen und die Arme mit der Achse 1 zu drehen.

Um ein konstant geringes Drehmoment für die Drehung der Sensorarme 10 zu erreichen, ist es zweckmässig, letztere bezüglich Ihrer Drehachse 1 auszubalancieren. Für die Leiterführung zu den Lichtschranken 6,7 ist die Verwendung hochflexibler Litzen oder einzelner Drähte vorteilhaft.

Als Antrieb für die Drehbewegung der Lichtschranken 6,7 dient ein Schrittmotor 11, welcher vorzugsweise über ein Getriebe 12, 13, 14, 15, 16 mit der Stange 19 verbunden ist. Zur Schonung der Lichtschranken kann dem Schrittmotor 11 eine Rutschkupplung nachgeschaltet sein, die ein Verdrehen der Arme 10 über einen festen Anschlag bei vorzugsweise 99° hinaus verhindert. Bekannt sind Miniaturschrittmotoren mit 180° Umdrehung pro Schritt. Mit einem 1:20 untersetzenden Getriebe 12, 13, 14, 15, 16 werden die Sensoren 18 pro Schritt um 9° verdreht. Die Zählung der ausgeführten Schritte ermöglicht die Bestimmung des momentanen Drehwinkels der Arme 10; damit dient der Schrittmotor 11 gleichzeitig als zweite Einrichtung zur Detektion des Zählerstandes.

Zum elektronischen Ablesen werden die Arme 10 gegenüber den Zahlenrollen 2 um 99° verdreht. Dabei geben die Lichtschranken 6,7 beim Passieren der Markierungen 21 an den Innen- und Aussenkränzen 8, 9 Signale ab. Vorzugsweise wird jeweils der Schaltzustand eines bistabilen Kippschalters geändert.

Als zweite Einrichtung zur Detektion des Zählerstandes kann auch eine mit der ersten Einrichtung mitdrehend verbundene Schlitzscheibe dienen, die von einer weiteren festen Lichtschranke zur Bestimmung des Drehwinkels abgelesen wird.

Figur 2 zeigt eine Ausführung mit achsialen Lichtschranken 20, welche bei Verdrehung gegenüber den Zahlenrollen 2 beim Passieren der als Markierungen 21 verwendeten Öffnungen 24 an den Zahlenrollen Signale erzeugen.

Figur 3 zeigt eine Seitenansicht gemäss Figur 2 in der verschiedene Drehstellungen der Lichtschranken 20 an Armen 22 erkennbar sind. Die Zahlenrollen 2 tragen Markierungen 21 in Form von axialen Durchbrüchen oder Öffnungen 24 und dazwischenliegenden Stegen 23.

Figur 4 zeigt eine bevorzugte Ausführung der Markierungen 21 für achsiale Lichtschranken mit der Anordnung der Stege 23 und Öffnungen 24. Die Stege 23 sind in Winkeln von 27°, 18°, 36°, 54° und 45° ausgeführt. Dazwischen befinden sich Öffnungen 24 von 54°, 45°, 27°, 18° und 36°. Bei jedem Wechsel von Steg zu Öffnung und umgekehrt wird von der Lichtschranke 20 jeweils ein Signal ausgelöst und ein Schalter umgeschaltet.

Die Öffnungen 24 sind generell ungleichmässig über den Umfang verteilt und können zusätzlich unterschiedliche Länge aufweisen. Die Markierungen 5, 21 können auch aus Magnetsegmenten oder Magneten unterschiedlicher Stärke bestehen, die von einem Magnetfeldsensor oder einem magnetisierbaren Sensor erkannt werden. In diesem zeichnerisch nicht dargestellten Fall ist jeweils nur ein einseitig jeder Zahlenrolle 2 zugeordneter Sensor erforderlich.

Das Rollenzählwerk arbeitet mechanisch ganz konventionell. Von jeweils zwei Zahlenrollen 2 wird die höherwertige Zahlenrolle 2 von der niederwertigen im letzten Zehntel deren Umdrehung über das dazwischenliegende Schaltritzel 3 um eine Zehntelumdrehung weitergedreht. Durch eine Blende kann der jeweilige Zählerstand abgelesen werden. Ausserdem oder gegebenenfalls auch ausschliesslich kann das Zählwerk noch elektronisch ausgelesen werden.

Zum elektronischen Auslesen des Rollenzählwerks wird der Schrittmotor 11 in Gang gesetzt und um 11 Schritte bzw. 99° weiterbewegt. Bei jedem Schritt werden für jede Zahlenrolle 2 die von den Lichtschranken 6,7,20 aufgenommenen Signale registriert. Diese sind jeweils einem bestimmten Schritt, d.h. Drehwinkelsignal des Schrittmotors 11 durch logische Verknüpfung zugeordnet. Durch Vergleich mit dem abgespeicherten Markierungsmuster, z.B. Markierungen nacheinander in den Abständen von 9°, 72°, 27°, 63°, 36°, 54°, 18° und 81°, kann für jede Zahlenrolle die momentane Drehstellung und damit der angezeigte Zahlenwert ermittelt werden.

### Bezugszahlen:

- 1: Zahlenrollenachse
- 2: Zahlenrollen
- 3: Schaltritzel
- 4: Zahnrad
- 5: Markierung
- 6: Gabellichtschranke
- 7: Gabellichtschranke
- 8: Aussenkranz
- 9: Innenkranz
- 10: Arm
- 11: Schrittmotor
- 12: Getriebe
- 13: Getriebe
- 14: Getriebe
- 15: Getriebe
- 16: Getriebe
- 17: Lichtquelle
- 18: Sensor
- 19: Stange
- 20: achsiale Lichtschranke
- 21: Markierung
- 22: Arm
- 23: Steg
- 24: Öffnung

## Patentansprüche

1. Mehrstelliges Rollenzählwerk für Volumenmessgerät für Gas Wasser oder für Elektrizitätszähler, in welchem von jeweils zwei Zahlenrollen (2) die höherwertige Zahlenrolle (2) von der niederwertigen im letzten Zehntel deren Umdrehung über ein Schaltritzel (3) um eine Zehntelumdrehung weitergedreht wird, **gekennzeichnet dadurch**, dass auf der Achse (1) der Zahlenrollen (2) oder auf einer Achse parallel zur Achse (1) der Zahlenrollen (2) jeweils zwischen den Zahlenrollen (2) je eine um einen Winkel kleiner als 360° drehbare erste Einrichtung (6, 7, 20) angebracht ist, welche bei einer Drehung relativ zu den Zahlenrollen (2) mindestens zwei Signale relativ zur Stellung der Zahlenrollen (2) abgibt, sowie mit einer zweiten, die erste Einrichtung (6, 7, 20) für eine Auslesung in Drehung versetzende Einrichtung (11), welche Signale zur Erkennung des momentanen absoluten Drehwinkels der ersten Einrichtung (6, 7, 20) erzeugt, und mit einer logischen Verknüpfung zwischen den Signalen der ersten Einrichtung (6, 7, 20) und den Drehwinkelsignalen der zweiten Einrichtung derart, dass die momentane Winkelstellung jeder Zahlenrolle (2) bestimmbar ist.

2. Mehrstelliges Rollenzählwerk nach Anspruch 1, gekennzeichnet dadurch, dass die um einen Winkel kleiner als 360° drehbaren Einrichtungen (6,7,20) zur Erzeugung von mindestens zwei Signalen aus je auf einem Arm (10) radial befestigten Gabellichtschranken (6,7) bestehen, deren Lichtstrahl durch an der Zahlenrolle (2) angebrachte Markierungen (5,21), z.B. in Form von Ringsegmenten von unterschiedlicher Länge unterbrochen wird.

3. Mehrstelliges Rollenzählwerk nach Anspruch 1, gekennzeichnet dadurch, dass die um einen Winkel kleiner als 360° drehbaren Einrichtungen zur Erzeugung von mindestens zwei Signalen aus Armen (10) bestehen, auf welchen jeweils auf einer Seite der Markierung (5,21) der Zahlenrolle (2) ein Lichtempfänger (18) und auf der anderen Seite eine Lichtquelle (17) angebracht ist, deren Lichtstrahl durch in der Zahlenrolle (2) in ungleichmässiger Verteilung angebrachte Öffnungen (24) freigegeben wird.

4. Mehrstelliges Rollenzählwerk nach Anspruch 2 oder 3, gekennzeichnet dadurch, dass der Lichtstrahl durch in ungleichmässiger Verteilung angebrachte Öffnungen (24) unterschiedlicher Länge freigegeben wird.

5. Mehrstelliges Rollenzählwerk nach Anspruch 1, gekennzeichnet dadurch, dass die um einen Winkel kleiner als 360° drehbaren ersten Einrichtungen aus Armen bestehen, auf welchen je ein Magnetfeldsensor angebracht ist, welcher durch an den Zahlenrollen angebrachte Magnete unterschiedlicher Stärke bei Drehung ein oder mehrere Signale abgibt.

6. Mehrstelliges Rollenzählwerk nach Anspruch 1, gekennzeichnet dadurch, dass die um einen Winkel kleiner als 360° drehbaren ersten Einrichtungen aus Armen bestehen, auf welchen je ein Magnetfeldsensor angebracht ist, welcher durch an den Zahlenrollen in ungleichmässiger Verteilung angebrachte Magnete bei Drehung mindestens zwei Signale abgibt.

7. Mehrstelliges Rollenzählwerk nach Anspruch 1, gekennzeichnet dadurch, dass die um einen Winkel kleiner als 360° drehbaren ersten Einrichtungen aus Armen bestehen, auf welchen je ein Magnetfeldsensor angebracht ist, welcher durch an den Zahlenrollen angebrachte unterschiedlich stark magnetisierbare Teile bei Drehung ein oder mehrere Signale abgibt.

8. Mehrstelliges Rollenzählwerk nach Anspruch 1, gekennzeichnet dadurch, dass die um einen Winkel kleiner als 360° drehbaren ersten Einrichtungen aus Armen bestehen, auf welchen je ein Magnetfeldsensor angebracht ist, welcher durch an den Zahlenrollen in ungleichmässiger Verteilung angebrachte magnetisierende Teile bei Drehung mindestens zwei Signale abgibt.

9. Mehrstelliges Rollenzählwerk nach einem der Ansprüche 1 bis 8, gekennzeichnet dadurch, dass mit der Verdrehung der ersten Einrichtungen über eine Rutschkupplung die Zahlenrollen (2) an Ihren Anschlag gedreht werden.

10. Mehrstelliges Rollenzählwerk nach einem der vorhergehenden Ansprüche, gekennzeichnet dadurch, dass die zweite Einrichtung zur Erkennung des momentanen Drehwinkels der ersten Einrichtung (6,7,20) aus einer mit der ersten Einrichtung (6,7,20) mitdrehend verbundenen Schlitzsscheibe und einer weiteren festen Gabellichtschranke besteht.

11. Mehrstelliges Rollenzählwerk nach einem der vorhergehenden Ansprüche, gekennzeichnet dadurch, dass die ersten Einrichtungen (6,7,20) über einen Schrittmotor (11) mit Untersetzungsgetriebe verdreht werden, und dass die Anzahl Schritte des Schrittmotors zur Erkennung des momentanen Drehwinkels der ersten Einrichtung (6,7,20) verwendet wird.

## Claims

1. Multidigit roller counting mechanism for an electricity meter or for a volume-measuring instrument for gas or water, in which mechanism the higher value number wheel (2) of each two number wheels (2) is rotated further through a tenth of one revolution by way of a switching pinion (3) by the lower value one in the last tenth of its revolution, characterised in that a first equipment (6, 7, 20), which is rotatable through an angle of less than 360° and which on a rotation relative to the number wheels (2) delivers at least two signals relating to the setting of the number wheels (2), is mounted on the axle (1) of the number wheels (2) or on an axle parallel to the axle (1) of the number wheels (2) and each time between the number wheels (2), as well as with a second equipment (11), which sets the first equipment (6, 7, 20) into rotation for a read-out and produces signals for the recognition of the instantaneous absolute rotary angle of the first equipment (6, 7, 20) and with a logical interlinking between the signals of the first equipment (6, 7, 20) and the rotary angle signals of the second equipment in such a manner that the instantaneous angular setting of each number wheel (2) is ascertainable.

2. Multidigit roller counting mechanism according to claim 1, characterised in that the equipments (6, 7, 20), which are rotatable through an angle of less than 360°, for the production of at least two signals consist of fork light barriers (6, 7), which are each fastened radially on a respective arm (10) and the light beam of which is interrupted by markings (5, 21), for example in the form of annular segments of different length, applied at the number wheel (2).

3. Multidigit roller counting mechanism according to claim 1, characterised in that the equipments which are rotatable through an angle of less than 360°, for the production of at least two signals consist of arms (10), on which a light receiver (18) is mounted each time on the one side of the marking (5, 21) of the number wheel (2) and a light source (17), the light beam of which is freed by openings (24) formed in non-uniform distribution in the number wheel (2), is mounted each time on the other side.

4. Multidigit roller counting mechanism according to claim 2 or 3, characterised in that the light beam is freed through openings (24) of different lengths and formed in non-uniform distribution.

5. Multidigit roller counting mechanism according to claim 1, characterised in that the first equipments, which are rotatable through an angle of less than 360°, consist of arms, on each of which a respective magnetic field sensor is mounted, which on rotation delivers one or more signals by magnets of different strength mounted at the number wheels.

6. Multidigit roller counting mechanism according to claim 1, characterised in that the first equipments, which are rotatable through an angle of less than 360°, consist of arms, on each of which a respective magnetic field sensor is mounted, which on rotation delivers at least two signals by magnets mounted at the number wheels in non-uniform distribution.

7. Multidigit roller counting mechanism according to claim 1, characterised in that the first equipments, which are rotatable through an angle of less than 360°, consist of arms, on each of which a respective magnetic field sensor is mounted, which on rotation delivers one or more signals by parts magnetisable to different strengths mounted at the number wheels.

8. Multidigit roller counting mechanism according to claim 1, characterised in that the first equipments, which are rotatable through an angle of less than 360°, consist of arms, on each of which a respective magnetic field sensor is mounted, which on rotation delivers at least two signals by magnetising parts mounted at the number wheels in non-uniform distribution.

9. Multidigit roller counting mechanism according to one of the claims 1 to 8, characterised in that the number wheels (2) are rotated against their abutment by way of a slipping clutch by the rotation of the first equipments.

10. Multidigit roller counting mechanism according to one of the preceding claims, characterised in that the second equipment for recognition of the instantaneous rotary angle of the first equipment (6, 7, 20) consists of a slotted disc, which is connected with the first equipment (6, 7, 20) to rotate therewith, and of a further fixed fork light barrier.

11. Multidigit roller counting mechanism according to one of the preceding claims, characterised in that the first equipments (6, 7, 20) are rotated by way of a stepping motor (11) with reduction gear and that the number of steps of the stepping motor is used for recognition of the instantaneous rotary angle of the first equipment (6, 7, 20).

## Revendications

1. Compteur à rouleaux à plusieurs chiffres pour un appareil de mesure volumétrique pour le gaz ou l'eau, ou pour des compteurs électriques, dans lequel sur deux rouleaux à chiffres (2), le rouleau à chiffres (2) de plus faible valeur, lors de son dernier dixième de tour, fait tourner le rouleau à chiffres (2) de plus grande valeur d'un dixième de tour par l'intermédiaire d'un pignon d'accouplement (3),
caractérisé en ce que sur l'axe (1) des rouleaux à chiffres (2) ou sur un axe parallèle à l'axe (1) des rouleaux à chiffres (2), il est prévu entre deux rouleaux (2) un premier dispositif (6, 7, 20) apte à tourner suivant un angle inférieur à 360°, qui, en tournant par rapport aux rouleaux à chiffres (2), émet au moins deux signaux relatifs à la position des rouleaux (2), un second dispositif (11) qui fait tourner le premier dispositif (6, 7, 20) pour une lecture et qui génère des signaux en vue de reconnaître l'angle de rotation absolu du moment du premier dispositif (6, 7, 20), et une liaison logique entre les signaux du premier dispositif (6, 7, 20) et les signaux d'angle de rotation du second, de telle sorte que la position angulaire du moment de chaque rouleau à chiffres (2) peut être définie.

2. Compteur à rouleaux à plusieurs chiffres selon la revendication 1, caractérisé en ce que les dispositifs (6, 7, 20), aptes à tourner suivant un angle inférieur à 360°, qui sont destinés à générer au moins deux signaux se composent de barrières lumineuses à fourche (6, 7) qui sont fixées chacune radialement sur un bras (10) et dont le rayon lumineux est interrompu par des marquages (5, 21) prévus sur le rouleau à chiffres (2), par exemple sous la forme de segments annulaires de différentes longueurs.

3. Compteur à rouleaux à plusieurs chiffres selon la revendication 1, caractérisé en ce que les dispositifs, aptes à tourner suivant un angle inférieur à 360°, qui sont destinés à générer au moins deux signaux se composent de bras (10) sur lesquels sont prévus un récepteur de lumière (18), d'un côté du marquage (5, 21) du rouleau à chiffres (2), et une source lumineuse (17), de l'autre côté, dont le rayon lumineux est libéré grâce à des ouvertures (24) réparties de façon irrégulière dans le rouleau à chiffres (2).

4. Compteur à rouleaux à plusieurs chiffres selon la revendication 2 ou 3, caractérisé en ce que le rayon lumineux est libéré grâce à des ouvertures (24) de différentes longueurs qui sont réparties de façon irrégulière dans le rouleau à chiffres (2).

5. Compteur à rouleaux à plusieurs chiffres selon la revendication 1, caractérisé en ce que les premiers dispositifs, aptes à tourner suivant un angle inférieur à 360°, se composent de bras (10) sur lesquels sont prévus des capteurs de champ magnétique respectifs qui émettent un ou plusieurs signaux, lors d'une rotation, grâce à des aimants d'épaisseurs différentes prévus sur les rouleaux à chiffres.

6. Compteur à rouleaux à plusieurs chiffres selon la revendication 1, caractérisé en ce que les premiers dispositifs, aptes à tourner suivant un angle inférieur à 360°, se composent de bras sur lesquels sont prévus des capteurs de champ magnétique respectifs qui émettent au moins deux signaux, lors d'une rotation, grâce à des aimants répartis de façon irrégulière sur les rouleaux à chiffres.

7. Compteur à rouleaux à plusieurs chiffres selon la revendication 1, caractérisé en ce que les premiers dispositifs, aptes à tourner suivant un angle inférieur à 360°, se composent de bras sur lesquels sont prévus des capteurs de champ magnétique respectifs qui émettent un ou plusieurs signaux, lors d'une rotation, grâce à des éléments prévus sur les rouleaux à chiffres et magnétisables suivant des intensités différentes.

8. Compteur à rouleaux à plusieurs chiffres selon la revendication 1, caractérisé en ce que les premiers dispositifs, aptes à tourner suivant un angle inférieur à 360°, se composent de bras sur lesquels sont prévus des capteurs de champ magnétique respectifs qui émettent au moins deux signaux, lors d'une rotation, grâce à des éléments magnétisants répartis de façon irrégulière sur les rouleaux à chiffres.

9. Compteur à rouleaux à plusieurs chiffres selon l'une des revendications 1 à 8, caractérisé en ce que grâce à la rotation des premiers dispositifs par l'intermédiaire d'un accouplement patinant, les rouleaux à chiffres (2) tournent jusqu'à leur butée.

10. Compteur à rouleaux à plusieurs chiffres selon l'une des revendications précédentes, caractérisé en ce que le second dispositif pour reconnaître l'angle de rotation du moment du premier dispositif (6, 7, 20) se compose d'un disque fendu qui est relié au premier dispositif (6, 7, 20) de manière à pouvoir tourner avec celui-ci, et d'une autre barrière lumineuse à fourche fixe.

11. Compteur à rouleaux à plusieurs chiffres selon l'une des revendications précédentes, caractérisé en ce que les premiers dispositifs (6, 7, 20) tournent par l'intermédiaire d'un moteur pas-à-pas (11) à démultiplicateur, et en ce que le nombre de pas du moteur pas-à-pas est utilisé pour reconnaître l'angle de rotation du moment du premier dispositif (6, 7, 20).
